# EUROPEAN PATENT APPLICATION

(11) **EP 4 815 311 A1**
(43) Date of publication of application: **30.09.2026**
(21) Application number: 25217129.3
(22) Date of filing: 19.11.2025
(51) Int. Cl.: H03L 7/091, H03L 7/093, H03L 7/10

(54) **PHASE LOCKED LOOP CIRCUIT TO MINIMIZE CIRCUIT NOISE**

(30) Priority: 26.03.2025 KR 20250038865
(71) Applicant: Korea University Research and Business Foundation, Seoul 02841 (KR)
(72) Inventor: SIM, CHANG-MIN, Seoul (KR); KIM, Chulwoo, Seoul (KR)
(74) Representative: RGTH

(57) **Abstract**

The present application relates to a phase locked loop circuit. The phase locked loop circuit according to some embodiments of the present disclosure includes: a control voltage generation unit configured to generate a control voltage by comparing a reference signal with a feedback signal, and control a common mode noise by adjusting a common mode voltage of the control voltage based on a trip point of an inverter circuit; and a voltage controlled oscillator configured to output an output signal in response to the control voltage and feed back the output signal to the feedback signal, wherein the inverter circuit may modulate the noise of the bias charge pump to the common mode noise through a replica path electrically connected to a rear end of the bias charge pump.

## Description

### CROSS-REFERENCE TO RELATED APPLICATIONS

This application claims priority under 35 U.S.C. § 119 to Korean Patent Application No. 10-2025-0038865 filed on March 26, 2025, in the Korean Intellectual Property Office, the disclosures of which are incorporated by reference herein in their entireties.

### BACKGROUND

The present invention relates to a phase locked loop circuit for minimizing noise in a circuit.

The Phase-Locked Loop (PLL) circuit corrects the frequency by comparing the phases of the reference signal and the output signal, and maintains a constant frequency. To this end, the conventional PLL includes a phase detector PD, a charge pump CP, a loop filter LP, and a voltage controlled oscillator VCO.

In particular, in the circuit design of the sub-sampling PLL and Sampling PLL scheme, which has recently emerged, it is possible to effectively reduce in-band noise by providing a high phase detection gain.

However, there is a problem in that in-band noise should be further reduced due to a high frequency multiplier ratio and a relatively low phase detection gain of the phase locked loop circuit.

### SUMMARY

The present invention is to solve the above problems, and an object of the present invention is to provide a phase locked loop circuit that minimizes circuit noise.

The present invention comprises: a control voltage generation unit for generating a control voltage by comparing a reference signal and a feedback signal, and controlling a common mode noise by adjusting a common mode voltage of the control voltage on the basis of a trip point of an inverter circuit; and a voltage control oscillator for outputting an output signal in response to the control voltage, and feeding back the output signal as the feedback signal, wherein the inverter circuit can modulate the noise of the bias charge pump into the common mode noise through a replica path electrically connected to a rear end of the bias charge pump.

In some embodiments, the control voltage generation unit may include a duty cycle correction circuit configured to correct the reference signal to a target duty cycle based on a sampling voltage and output the corrected reference signal as a buffer voltage, a phase detector configured to receive the buffer voltage and the feedback signal, detect a phase difference between the buffer voltage and the feedback signal, and output the sampling voltage according to the phase difference, a charge pump configured to receive the sampling voltage, convert the sampling voltage into a current signal, and output the current signal, a loop filter configured to receive the current signal, filter the current signal, and convert the current signal into the control voltage, and a common mode feedback circuit configured to control the common mode voltage of the control voltage.

In some embodiments, the bias charge pump may include a constant GM circuit configured to generate a bias voltage according to a power supply voltage applied to the bias charge pump, and an inverter circuit connected to an output terminal of the constant GM circuit and including a first inverter and a second inverter having a replica structure.

In some embodiments, the first inverter and the second inverter may be implemented as an inverter having a CMOS structure.

In some embodiments, the phase locked loop circuit may further include a divider configured to divide the output signal according to a preset division value.

The present invention comprises: a control voltage generation unit for generating a control voltage by comparing a reference signal with a feedback signal, and controlling a common mode noise by adjusting a common mode voltage of the control voltage on the basis of a trip point of an inverter circuit; and a voltage control oscillator for outputting an output signal in response to the control voltage, and feeding back the output signal as the feedback signal, wherein the inverter circuit modulates the noise of a bias charge pump into the common mode noise through a replica path electrically connected to a rear end of a bias charge pump, and the voltage control oscillator comprises a cross-coupling circuit in which gate ends of a plurality of transistors are implemented as a TC.

In some embodiments, the control voltage generation unit may include a duty cycle correction circuit configured to correct the reference signal to a target duty cycle based on a sampling voltage and output the corrected reference signal as a buffer voltage, a phase detector configured to receive the buffer voltage and the feedback signal, detect a phase difference between the buffer voltage and the feedback signal, and output the sampling voltage according to the phase difference, a charge pump configured to receive the sampling voltage, convert the sampling voltage into a current signal, and output the current signal, a loop filter configured to receive the current signal, filter the current signal, and convert the current signal into the control voltage, and a common mode feedback circuit configured to control the common mode voltage of the control voltage.

In some embodiments, the bias charge pump may include a constant GM circuit configured to generate a bias voltage according to a power supply voltage applied to the bias charge pump, and an inverter circuit connected to an output terminal of the constant GM circuit and including a first inverter and a second inverter having a replica structure.

In some embodiments, the first inverter and the second inverter may be implemented as an inverter having a CMOS structure.

In some embodiments, the phase locked loop circuit may further include a divider configured to divide the output signal according to a preset division value.

The phase locked loop circuit according to embodiments of the present disclosure may modulate noise generated in the bias charge pump into common mode noise through an inverter circuit having a replica path, and may minimize noise of a signal output from the phase locked loop circuit by correcting the noise.

### BRIEF DESCRIPTION OF THE FIGURES

The above and other objects and features of the present disclosure will become apparent by describing in detail embodiments thereof with reference to the accompanying drawings.
FIG. 1 is a block diagram of a phase locked loop circuit in accordance with some embodiments of the present application.
FIG. 2 is a schematic circuit diagram for a phase locked loop circuit according to some embodiments of the present application.
FIG. 3 is a circuit diagram illustrating an example of a bias charge pump according to some embodiments of the present application.
FIG. 4 is a circuit diagram illustrating an example of a voltage controlled oscillator according to some embodiments of the present application.
FIG. 5 is a flowchart illustrating a method of operating a phase locked loop circuit according to some embodiments of the present application.

### DETAILED DESCRIPTION

Hereinafter, embodiments of the present disclosure will be described in detail with reference to the accompanying drawings.

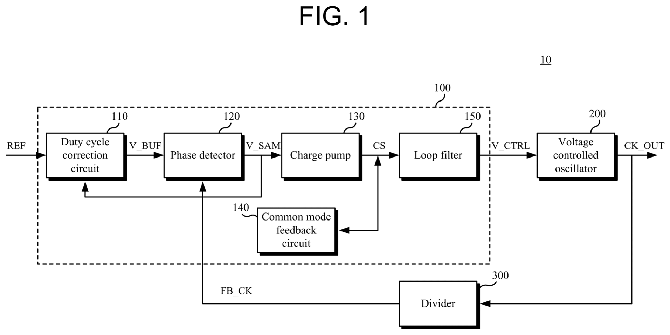

FIG. 1 is a block diagram of a phase locked loop circuit in accordance with some embodiments of the present application.

Referring to FIG. 1, a Phase Locked Loop (PLL) circuit 10 according to some embodiments may include a control voltage generation unit 100, a voltage controlled oscillator 200, and a divider 300.

In some embodiments, the phase locked loop circuit 10 may be implemented in a transmitter to transmit data. For example, the phase locked loop circuit 10 may be applied to transmitters of various devices such as a 5G and broadband communication system, a radar signal processing system, a high-speed image and image sensor system, and a medical image processing device.

The control voltage generation unit 100 may generate a control voltage V_CTRL by comparing a reference signal REF provided from the outside with a feedback signal FB_CLK. In other words, the control voltage generation unit 100 may compare the reference signal REF with the feedback signal FB_CLK fed back from the voltage controlled oscillator 200, and generate the control voltage V_CTRL according to the difference. Here, the control voltage V_CTRL is a differential signal and may be a positive control voltage and a negative control voltage.

In addition, the control voltage generation unit 100 may include a plurality of inverter circuits to control the common mode noise by adjusting the common mode voltage of the control voltage V_CTRL based on a trip point of the inverter circuit. Accordingly, the control voltage generation unit 100 may reduce a phase shift (Jitter) and a signal distortion, and may provide a stable control voltage.

To this end, the control voltage generation unit 100 may include a Duty Cycle Corrector (DCC) circuit 110, a Phase Detector 120, a Charge Pump 130, a Common Mode Feedback (CMFB) circuit 140, and a Loop Filter 150.

The duty cycle correction circuit 110 may adjust the duty ratio of the reference signal REF based on the sampling voltage V_SAM. Here, the sampling voltage V_SAM may be an output voltage output from the phase detector 120.

More specifically, the duty cycle correction circuit 110 may correct the target duty cycle by adjusting the high and low sections of the reference signal REF based on the sampling voltage V_SAM output from the phase detector 120. In addition, the duty cycle correction circuit 110 may output the reference signal REF corrected to the target duty cycle as the buffer voltage V_BUF.

The phase detector 120 may receive the buffer voltage V_BUF output from the duty cycle correction circuit 110 and may receive a feedback signal from the voltage controlled oscillator 200 or the divider 300. More specifically, the phase detector 120 may detect a phase difference between the input buffer voltage V_BUF and the feedback signal to output the sampling voltage V_SAM according to the phase difference. Here, the sampling voltage V_SAM may be a differential signal.

In addition, the sampling voltage V_SAM output from the phase detector 120 may be fed back to the duty cycle correction circuit 110.

The charge pump 130 may be electrically connected to the phase detector 120 to receive the sampling voltage V_SAM. The charge pump 130 may convert the sampling voltage V_SAM output from the phase detector 120 into a current signal CS and output the current signal CS. In other words, the charge pump 130 may generate the current signal CS for generating the control voltage V_CTRL based on the detection result received from the phase detector 120.

The common mode feedback circuit 140 may be electrically connected to the charge pump 130 to receive the current signal CS. The common mode feedback circuit 140 is a circuit for controlling the common mode voltage in the differential signal system, and may maintain the common mode voltage of the current signal CS constant. Accordingly, the common mode feedback circuit 140 may control the common mode noise of the current signal CS transmitted to the loop filter 150.

In more detail, the common mode feedback circuit 140 may detect the common mode voltage of the current signal CS and compare the common mode voltage with a preset reference voltage to determine whether common mode noise occurs. In addition, when the common mode voltage VCOM is higher or lower than the reference value, the common mode feedback circuit 140 may correct the common mode voltage by adjusting the bias voltage. Accordingly, the common mode feedback circuit 140 may control the common mode noise.

The loop filter 150 may be electrically connected to the charge pump 130 to receive the current signal CS. In more detail, the loop filter 150 may receive the current signal CS in which the common mode noise is minimized from the common mode feedback circuit 140, filter the current signal CS, and convert the filtered current signal CS into the control voltage V_CTRL. In addition, the loop filter 150 may transmit the control voltage V_CTRL to the voltage controlled oscillator 200.

The voltage controlled oscillator 200 may be electrically connected to the loop filter 150 to receive the control voltage V_CTRL. In addition, the voltage controlled oscillator 200 may generate the output signal CK_OUT having a frequency corresponding to the control voltage V_CTRL, and transmit the output signal CK_OUT as a feedback signal to the control voltage generation unit 100.

In some embodiments, the phase locked loop circuit 10 may further include the divider 300. The divider 300 may be electrically connected to the voltage controlled oscillator 200 to receive the output signal CK_OUT. In addition, the divider 300 may generate the feedback signal FB_CLK by dividing the output signal CK_OUT according to a preset division value, and transmit the feedback signal FB_CLK as a feedback signal to the control voltage generation unit 100. In some embodiments, the divider 300 may be implemented as an integer divider, but is not limited thereto.

As described above, the phase locked loop circuit 10 according to some embodiments of the present disclosure may modulate the noise generated in the bias charge pump into the common mode noise and correct the common mode noise through the common mode feedback circuit 140, thereby minimizing the noise of the signal output from the transmission end.

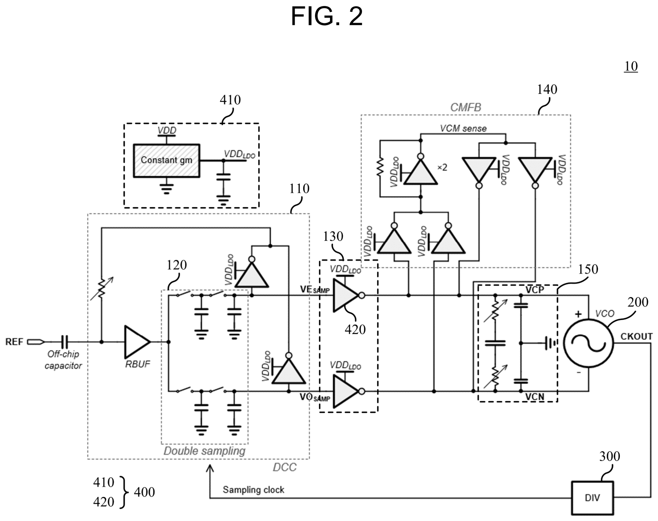

FIG. 2 is a schematic circuit diagram for a phase locked loop circuit according to some embodiments of the present application. Specifically, FIG. 2 is similar to the phase locked loop circuit 10 of FIG. 1. Therefore, a redundant description of the same phase locked loop circuit 10 will be omitted below.

Referring to FIG. 2, the phase locked loop circuit 10 may include a plurality of inverter circuits 420. In more detail, each of the duty cycle correction circuit 110, the charge pump 130, and the common mode feedback circuit 140 may include a plurality of inverter circuits 420.

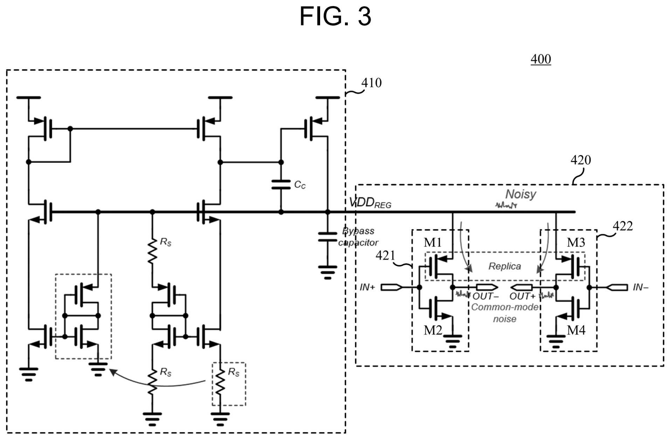

The inverter circuit 420 may be electrically connected to a rear end of the constant GM circuit 410 to operate based on a bias voltage. Here, the bias voltage may be an output voltage of LDO. A more detailed description of the constant GM circuit 410 and the inverter circuit 420 will be described below with reference to FIG. 3.

In some embodiments, the inverter circuit 420 may receive a bias voltage from the bias charge pump 400 and modulate the noise of the bias charge pump 400 into common mode noise through a replica path. In more detail, the inverter circuit 420 may amplify the differential signal using the bias voltage supplied from the constant GM circuit 410, and may modulate the noise generated in the constant GM circuit 410 into the common mode component through the replica path.

Accordingly, the inverter circuit 420 may convert the noise generated by the bias charge pump 400 into the common mode noise, thereby inducing the common mode feedback circuit 140 to remove the noise.

FIG. 3 is a circuit diagram illustrating an example of a bias charge pump according to some embodiments of the present application.

Referring to FIG. 3, the bias charge pump 400 may include a constant GM circuit 410 and an inverter circuit 420.

The constant GM circuit 410 may be implemented with a plurality of transistors, a plurality of resistors, a plurality of capacitors, and a plurality of transistors, and may generate a bias voltage according to a power supply voltage VDD applied to the bias charge pump 400.

The inverter circuit 420 may be electrically connected to a rear end of the bias charge pump 400 to operate based on a bias voltage. In detail, the inverter circuit 420 may be connected to an output terminal of the constant GM circuit 410, and may modulate noise generated in the bias charge pump 400 into a common mode component through the first inverter 421 and the second inverter 422 that are symmetrical to each other. That is, the first inverter 421 and the second inverter 422 may have a replica structure and may be designed to maintain the same electrical characteristics.

In some embodiments, the first inverter 421 and the second inverter 422 may be implemented as CMOS inverters, and may be disposed in a differential structure from each other. Accordingly, noise generated in the bias charge pump 400 may be modulated into a common mode component at the differential input terminal of the inverter circuit 420, and may be removed by the common mode feedback circuit 140 described above.

In some embodiments, the first inverter 421 may be implemented with a first transistor M1 and a second transistor M2. Here, the first transistor M1 may be PMOS, and the second transistor M2 may be NMOS. Each gate of the first transistor M1 and the second transistor M2 may be commonly connected to a positive input terminal, and a source of the first transistor M1 may be connected to an output path of the constant GM circuit 410. A drain of the first transistor M1 may be connected to a negative output terminal in common with a drain of the second transistor M2, and a source of the second transistor M2 may be connected to a ground terminal.

The second inverter 422 may be implemented with a third transistor M3 and a fourth transistor M4. Here, the third transistor M3 may be PMOS, and the fourth transistor M4 may be NMOS. Gates of the third transistor M3 and the fourth transistor M4 may be commonly connected to the negative input terminal, and a source of the third transistor M3 may be connected to an output path of the constant GM circuit 410. The drain of the third transistor M3 may be connected to the positive output terminal in common with the drain of the fourth transistor M4, and the source of the fourth transistor M4 may be connected to the ground terminal.

Accordingly, the first inverter 421 and the second inverter 422 may be optimized to have a high Common Mode Rejection Ratio (CMRR), and may modulate the noise of the bias charge pump 400 into the common mode component while maintaining the quality of the differential signal.

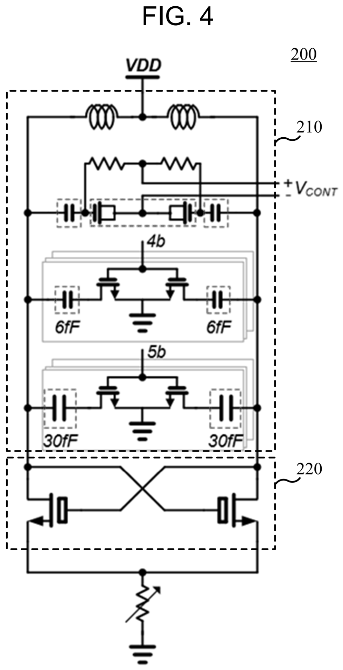

FIG. 4 is a circuit diagram illustrating an example of a voltage controlled oscillator according to some embodiments of the present application.

Referring to FIG. 4, a voltage controlled oscillator 200 according to some embodiments of the present disclosure may include a resonator 210 and a cross-coupling circuit 220.

The resonator 210 may include a plurality of inductors, a varactor, a plurality of resistors, and a plurality of metal oxide metal (MOM) capacitors. For example, the resonator 210 may generate the oscillation signal by varying the capacitance value through the varactor in a state in which the inductance values of the inductors are fixed. The cross-coupling circuit 220 may include a plurality of cross-coupled transistors. Here, the two transistors may have a thick gate oxide layer structure to stably guarantee operation even at a high voltage.

More specifically, the transistors of the cross-coupling circuit 220 may be implemented as a thick gate (TC) having an increased gate oxide film thickness. Accordingly, the cross-coupling circuit 220 may provide stable attenuation characteristics without gate oxide breakdown even at a high supply voltage.

In addition, the two transistors of the cross-coupling circuit 220 may be arranged in a differential structure, thereby minimizing asymmetry and reducing phase noise in the signal attenuation process.

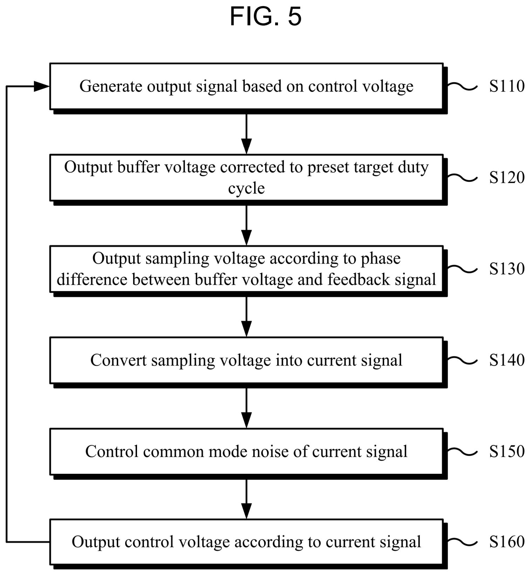

FIG. 5 is a flowchart illustrating a method of operating a phase locked loop circuit according to some embodiments of the present application.

Referring to FIG. 5, in step S110, an output signal CK_OUT of which a frequency is adjusted based on a control voltage V_CTRL may be generated. For example, the voltage controlled oscillator 200 may be electrically connected to the loop filter 150 to receive the control voltage V_CTRL. In addition, the voltage controlled oscillator 200 may generate the output signal CK_OUT having a frequency corresponding to the control voltage V_CTRL. In addition, the voltage controlled oscillator 200 may transmit the output signal CK_OUT as a feedback signal to the control voltage generation unit 100.

In some embodiments, the phase locked loop circuit 10 may further include the divider 300. The divider 300 may be electrically connected to the voltage controlled oscillator 200 to receive the output signal CK_OUT. In addition, the divider 300 may generate the feedback signal FB_CLK by dividing the output signal CK_OUT according to a preset division value, and transmit the feedback signal FB_CLK as a feedback signal to the control voltage generation unit 100.

In step S120, the reference signal REF may be corrected to a preset target duty cycle and may be output as the buffer voltage V_BUF. For example, the duty cycle correction circuit 110 may correct the target duty cycle by adjusting the high and low sections of the reference signal REF based on the sampling voltage V_SAM. In addition, the duty cycle correction circuit 110 may output the reference signal REF corrected to the target duty cycle as the buffer voltage V_BUF.

In step S130, a phase difference between the buffer voltage V_BUF and the feedback signal may be detected, and the sampling voltage V_SAM according to the phase difference may be output. For example, the phase detector 120 may receive the buffer voltage V_BUF output from the duty cycle correction circuit 110 and may receive a feedback signal from the voltage controlled oscillator 200 or the divider 300. In addition, the phase detector 120 may detect a phase difference between the input buffer voltage V_BUF and the feedback signal to output the sampling voltage V_SAM according to the phase difference.

In addition, the sampling voltage V_SAM output from the phase detector 120 may be fed back to the duty cycle correction circuit 110.

In step S140, the sampling voltage V_SAM may be converted into a current signal CS and output. For example, the charge pump 130 may convert the sampling voltage V_SAM output from the phase detector 120 into a current signal CS and output the current signal CS. In other words, the charge pump 130 may generate the current signal CS for generating the control voltage V_CTRL based on the detection result received from the phase detector 120.

In step S150, the common mode noise of the current signal CS may be removed through the common mode feedback circuit 140. For example, the common mode feedback circuit 140 may detect the common mode voltage of the current signal CS and compare the common mode voltage with a preset reference voltage to determine whether common mode noise occurs. In addition, when the common mode voltage is higher or lower than the reference value, the common mode feedback circuit 140 may correct the common mode voltage by adjusting the bias voltage. Accordingly, the common mode feedback circuit 140 may control the common mode noise.

In step S160, the current signal CS in which the common mode noise is minimized from the common mode feedback circuit 140 may be converted into the control voltage V_CTRL and output. For example, the loop filter 150 may receive the current signal CS in which the common mode noise is minimized from the common mode feedback circuit 140, filter the current signal CS, and convert the filtered current signal into the control voltage V_CTRL. In addition, the loop filter 150 may transmit the control voltage V_CTRL to the voltage controlled oscillator 200.

The above-described contents are specific embodiments for implementing the present application. In addition to the above-described embodiments, the present application will also include embodiments that may be simply changed in design or easily changed. In addition, the present application will also include techniques that can be easily modified and implemented using the embodiments. Accordingly, the scope of the present application should not be limited to the above-described embodiments, and should be defined by not only the scope of the claims to be described later but also the same as the scope of the claims of the present application.

This work was supported by the National Research Foundation of Korea (NRF) funded by the Ministry of Science and ICT (MSIT) (No. RS-2023-0281047).

## Claims

1. The phase locked loop circuit comprising:
a control voltage generation unit configured to generate a control voltage by comparing a reference signal with a feedback signal, and control a common mode noise by adjusting a common mode voltage of the control voltage based on a trip point of an inverter circuit; and
a voltage controlled oscillator configured to output an output signal in response to the control voltage and feed back the output signal to the feedback signal, wherein the inverter circuit modulates the noise of the bias charge pump to the common mode noise through a replica path electrically connected to a rear end of the bias charge pump.

2. The phase locked loop circuit of claim 1, wherein the control voltage generation unit comprises:
a duty cycle correction circuit configured to correct the reference signal to a target duty cycle based on a sampling voltage and output the corrected reference signal as a buffer voltage;
a phase detector configured to receive the buffer voltage and the feedback signal, detect a phase difference between the buffer voltage and the feedback signal, and output the sampling voltage according to the phase difference;
a charge pump configured to receive the sampling voltage, convert the sampling voltage into a current signal, and output the current signal;
a loop filter configured to receive the current signal, filter the current signal, and convert the current signal into the control voltage; and
a common mode feedback circuit configured to control the common mode voltage of the control voltage.

3. The phase locked loop circuit of claim 1, wherein the bias charge pump includes:
a constant GM circuit configured to generate a bias voltage according to a power supply voltage applied to the bias charge pump;
and an inverter circuit connected to an output terminal of the constant GM circuit and including a first inverter and a second inverter having a replica structure.

4. The phase locked loop circuit of claim 3, wherein the first inverter and the second inverter are implemented as inverters having a CMOS structure.

5. The phase locked loop circuit of claim 1, wherein the phase locked loop circuit further comprises a divider configured to divide the output signal according to a preset division value.

6. The phase locked loop circuit comprising:
a control voltage generation unit configured to generate a control voltage by comparing a reference signal with a feedback signal, and control a common mode noise by adjusting a common mode voltage of the control voltage based on a trip point of an inverter circuit; and
a voltage controlled oscillator configured to output an output signal in response to the control voltage and feed back the output signal to the feedback signal,wherein the inverter circuit modulates the noise of the bias charge pump into the common mode noise through a replica path electrically connected to a rear end of the bias charge pump, and wherein the voltage controlled oscillator comprises a cross-coupling circuit in which gate ends of a plurality of transistors are implemented as a TC.

7. The phase locked loop circuit of claim 6, wherein the control voltage generation unit comprises:
a duty cycle correction circuit configured to correct the reference signal to a target duty cycle based on a sampling voltage and output the corrected reference signal as a buffer voltage;
a phase detector configured to receive the buffer voltage and the feedback signal, detect a phase difference between the buffer voltage and the feedback signal, and output the sampling voltage according to the phase difference;
a charge pump configured to receive the sampling voltage, convert the sampling voltage into a current signal, and output the current signal;
a loop filter configured to receive the current signal, filter the current signal, and convert the current signal into the control voltage; and
a common mode feedback circuit configured to control the common mode voltage of the control voltage.

8. The phase locked loop circuit of claim 6, wherein the bias charge pump includes:
a constant GM circuit configured to generate a bias voltage according to a power supply voltage applied to the bias charge pump; and
an inverter circuit connected to an output terminal of the constant GM circuit and including a first inverter and a second inverter having a replica structure.

9. The phase locked loop circuit of claim 8, wherein the first inverter and the second inverter are implemented as inverters having a CMOS structure.

10. The phase locked loop circuit of claim 6, wherein the phase locked loop circuit further comprises a divider configured to divide the output signal according to a preset division value.
